# FASCICULE DE BREVET EUROPEEN

(11) **EP 0 802 442 B1**
(45) Date de publication et mention de la délivrance du brevet: **17.11.2004**
(21) Numéro de dépôt: 97400829.4
(22) Date de dépôt: 11.04.1997
(51) Int. Cl.: G02F 1/017, H01S 5/34, H01S 5/50

(54) **Structure à puits quantiques notamment pour composants actifs en onde guidée insensibles la polarisation et de grande puissance de saturation et composant comprenant cette structure**
Aktive polarisationsunabhängige Wellenleiterpotentialtopfstruktur mit einer hohen Sättigung und Vorrichtung unter Verwendung derselben
Multiple quantum well structure suitable for active optical waveguide devices such as modulators having a high saturation level and polarisation independence

(30) Priorité: 15.04.1996 FR 9604659
(43) Date de publication de la demande: 22.10.1997
(73) Titulaire: Avanex Corporation, Fremont, CA 94538 (US)
(72) Inventeur: Ougazzaden, Abdallah, 92260 Fontenay Aux Roses (FR); Devaux, Fabrice, 92120 Montrouge (FR)
(74) Mandataire: Haines, Miles John

(56) Documents cités:
- EP-A- 0 582 942
- APPLIED PHYSICS LETTERS, vol. 65, no. 20, 14 Novembre 1994, NEW YORK US, pages 2536-2538, XP002019578 X.S JIANG ET AL: "Strain compensated InAsP/InP/InGaP multiple quantum well for 1.5 mum wavelength"
- ELECTRONICS LETTERS, vol. 31, no. 20, 28 Septembre 1995, page 1749/1750 XP000538086 KASUKAWA A ET AL: "VERY LOW THRESHOLD CURRENT DENSITY 1.3 MU M INASP/INP/INGAP/INP/ GAINASP STRAIN-COMPENSATED MULTIPLE QUANTUM WELL LASERS"
- PATENT ABSTRACTS OF JAPAN vol. 012, no. 013 (E-573), 14 Janvier 1988 & JP 62 173788 A (NEC CORP), 30 Juillet 1987,
- ELECTRONICS LETTERS, vol. 30, no. 3, 3 Février 1994, pages 230-232, XP000431308 SUZUKI Y ET AL: "POLARISATION INSENSITIVE PHOTODETECTOR CHARACTERISTICS OF A TENSILE STRAINED BARRIER LASER DIODE"
- ELECTRONICS LETTERS, vol. 30, no. 9, 28 Avril 1994, page 698/699 XP000444107 SAHARA R ET AL: "ENGINEERING OF BARRIER BAND STRUCTURE FOR ELECTROABSORPTION MQW MODULATORS"

## Description

### DOMAINE TECHNIQUE

La présente invention concerne une structure à puits quantiques pour composants optiques actifs en onde guidée, cette structure comprenant des couches semiconductrices de puits qui alternent avec des couches semiconductrices de barrières.

L'invention concerne aussi un composant comprenant cette structure.

La présente invention s'applique notamment aux composants actifs en onde guidée, qui sont insensibles à la polarisation (« *polarization insensitive* ») et ont une grande puissance de saturation, c'est-à-dire un seuil de saturation élevé.

Elle s'applique tout particulièrement aux composants optoélectroniques qui sont formés sur des substrats de InP et destinés à la transmission d'informations à haut débit par l'intermédiaire de fibres optiques, à la longueur d'onde de 1,3 µm ainsi qu'à la longueur d'onde de 1,5 µm.

L'invention est particulièrement utilisable pour tout traitement de signal optique où sont nécessaires :
- une insensibilité à la polarisation de la lumière que l'on veut traiter et
- une capacité de travailler avec de fortes puissances optiques.

A titre d'exemple, l'invention s'applique aux portes optiques, aux dispositifs de remise en forme « en ligne » de signaux optiques, aux dispositifs de multiplexage ou de démultiplexage de signaux optiques, aux dispositifs de commutation optique et aux dispositifs de photo-détection.

En effet, pour ces applications, dans lesquelles la lumière incidente est issue d'une fibre optique, la polarisation de cette lumière est aléatoire.

Une insensibilité à la polarisation est nécessaire pour que les signaux détectés ou transmis ne soient pas influencés par cette fluctuation incontrôlable de polarisation.

De plus, pour beaucoup d'applications, la puissance optique incidente, transitoire ou continue, peut être très élevée (de l'ordre de quelques dizaines de mW).

C'est par exemple le cas dans les systèmes à solitons où la puissance-crête peut atteindre 100 mW pour des débits de 40 Gbits/s.

Or, dans une structure quantique insensible à la polarisation, l'absorption ne varie pas toujours de façon linéaire avec la puissance de la lumière injectée.

A partir d'une certaine puissance, il arrive que l'absorption soit saturée et cela se traduit par une dégradation des performances du composant contenant la structure.

Ce régime de saturation est lié au temps que mettent les porteurs de charge à s'échapper des puits quantiques vers les contacts du composant et, en particulier, au temps d'échappement des trous, à cause de la grande masse effective de ces derniers.

Pour augmenter la puissance de saturation, il est alors nécessaire de diminuer la hauteur des barrières des trous ainsi que la masse effective de ceux-ci.

### ÉTAT DE LA TECHNIQUE ANTÉRIEURE

On connaît déjà une structure à puits quantiques destinée à un composant optique actif en onde guidée, ce composant étant insensible à la polarisation et ayant une grande puissance de saturation.

Cette structure est décrite dans le document suivant auquel on se reportera :

K. Yoshino et al, « Polarization-independent electroabsorption modulator using strain-compensated InGaAs/InAlAs MQW structure », Proceedings of CLEO/Pacific RIM 95, p.277.

Dans cette structure connue, les couches de puits et les couches de barrières sont faites de matériaux semiconducteurs appartenant à la famille de matériaux InGaAlAs.

De plus, les couches de puits sont contraintes en tension (« *tensile strained*») tandis que les couches de barrières sont contraintes en compression (« *compressively strained* »).

L'utilisation de couches de puits contraintes en tension conduit à une insensibilité du composant à la polarisation tandis que l'utilisation de matériaux de la famille InGaAlAs conduit à une puissance de saturation relativement élevée.

Grâce à l'utilisation de ces matériaux, dans cette structure connue, le décalage (« offset ») des bandes d'énergie est intrinsèquement favorable à la diminution des barrières des trous.

Une puissance de saturation de 10 mW a été obtenue.

Cependant, bien que le décalage des bandes d'énergie soit favorable dans la famille InGaAlAs, la hauteur des barrières des trous reste élevée, ce qui conduit à une puissance de saturation limitée à des valeurs ne dépassant pas 10 mW environ.

De plus, l'utilisation de matériaux de la famille InGaAlAs présente de nombreuses incompatibilités technologiques avec l'intégration de dispositifs ayant différentes fonctions sur un même substrat.

Une autre structure à puits quantiques est décrite dans "Strain Compensated In ASP/Inp/InGap Multiple Quantum Well for 1.5 µm Wavelength" by Jiang, Appl Phys Lett 65(20) 14/11/94. Un autre document, qui révèle une structure à puits quantiques avec une couche intercalaire, est "Very low threshold current density InAsP/InP/InGaP/InP/GaInAsP strain compensated multiple quantum well lasers" de Kasukawa et al, Electronics Letters 31 (1995) p.1749-1750. Dans cette structure, les couches de barrières sont contraintes en tension tandis que les couches de puits sont contraintes en compression. La couche intercalaire sert à améliorer la qualité du cristal. Cette structure-ci peut être employée pour un laser ou aussi pour un modulateur optique.

### EXPOSÉ DE L'INVENTION

La présente invention a pour but de résoudre le problème de l'obtention d'une structure à puits quantiques, mécaniquement résistante, pour composants actifs en onde guidée qui sont insensibles à la polarisation et dont la puissance de saturation est grande et peut être nettement supérieure à la valeur de 10 mW mentionnée plus haut, sans avoir nécessairement à utiliser des matériaux de la famille InGaAlAs.

Pour résoudre ce problème, la présente invention utilise des couches de puits qui sont contraintes en tension et des couches de barrières qui sont également contraintes en tension.

L'utilisation de couches de puits contraintes en tension conduit à l'insensibilité des composants à la polarisation.

L'utilisation de couches de barrières contraintes en tension permet de réduire la hauteur des barrières des trous et permet donc aux composants de fonctionner sans saturation à de hautes puissances de lumière incidente.

De plus, pour que la structure de l'invention soit mécaniquement résistante, cette structure comprend des couches intercalaires qui sont électriquement et optiquement inactives, alternent avec des groupes de couches de puits et de couches de barrières et sont contraintes en compression de manière à compenser les contraintes de tension des couches de puits et des couches de barrières.

On choisit la composition et l'emplacement de ces couches intercalaires de manière à compenser ces contraintes de tension, à permettre d'épitaxier un nombre suffisant de couches de puits et de couches de barrières et à ne pas perturber le fonctionnement d'un composant dans lequel se trouve la structure et, en particulier, à ne pas perturber l'échappement des porteurs de charge.

La présente invention permet d'obtenir des barrières de trous de très faible hauteur, de l'ordre de quelques meV.

Plus généralement, la présente invention résout le problème de l'obtention d'une structure à puits quantiques, mécaniquement résistante, pour composants actifs en onde guidée, structure dans laquelle les couches de puits et les couches de barrières sont contraintes, la contrainte globale n'étant pas nulle.

Ces composants sont par exemple des lasers ou des amplificateurs optiques.

Pour résoudre ce problème, des couches intercalaires électriquement et optiquement inactives alternent avec des groupes de couches puits et de couches de barrières et sont choisies de manière à compenser la contrainte globale.

De façon précise, la présente invention a pour objet une structure à puits quantiques pour composant optique actif en onde guidée, cette structure comprenant des couches semiconductrices de puits qui alternent avec des couches semiconductrices de barrières, où les couches de puits et les couches de barrières sont contraintes, la contrainte résultante n'étant pas nulle, et en ce que la structure comprend en outre des couches intercalaires qui sont électriquement et optiquement inactives, alternent avec des groupes de couches de puits et de couches de barrières et sont aptes à compenser cette contrainte résultante, et où les couches de puits et les couches de barrières sont contraintes en tension, le composant étant ainsi insensible à la polarisation et de grande puissance de saturation, et les couches intercalaires sont contraintes en compression pour compenser les contraintes de tension dues aux couches de puits et aux couches de barrières.

Alors, il est préférable que la largeur de bande interdite (« *energy gap* » dans les publications en langue anglaise) des couches intercalaires soit supérieure ou égale à la largeur de bande interdite des couches de barrières.

Dans le cas de ce mode de réalisation particulier, les couches de puits, les couches de barrières et les couches intercalaires peuvent être faites de matériaux semiconducteurs appartenant à la famille de matériaux InGaAsP, qui est favorable à l'intégration, sur un même substrat de dispositifs ayant diverses fonctions, ou à la famille de matériaux InGaAlAs.

La présente invention concerne également un composant optique actif en onde guidée, caractérisé en ce qu'il comprend une structure conforme à l'invention.

La présente invention concerne en particulier un tel composant comprenant une couche active semiconductrice intrinsèque comprise entre une couche de confinement (« *cladding layer* ») semiconductrice de type n et une couche de confinement semiconductrice de type p, cette couche active comprenant la structure conforme à l'invention mentionnée plus haut, où les couches de puits et les couches de barrières sont toutes contraintes en tension, et permettant au composant de former un modulateur électro-absorbant à puits quantiques qui est insensible à la polarisation et qui a une grande puissance de saturation.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue en coupe schématique d'un modulateur électro-absorbant comprenant une structure à puits quantiques conforme à la présente invention,
- la figure 2 illustre schématiquement le diagramme de bandes de la structure conforme à l'invention que comprend le modulateur de la figure 1, et
- la figure 3 illustre schématiquement le diagramme de bandes d'une autre structure à puits quantiques conforme à la présente invention.

### EXPOSÉ DÉTAILLÉ DE MODES DE RÉALISATION PARTICULIERS

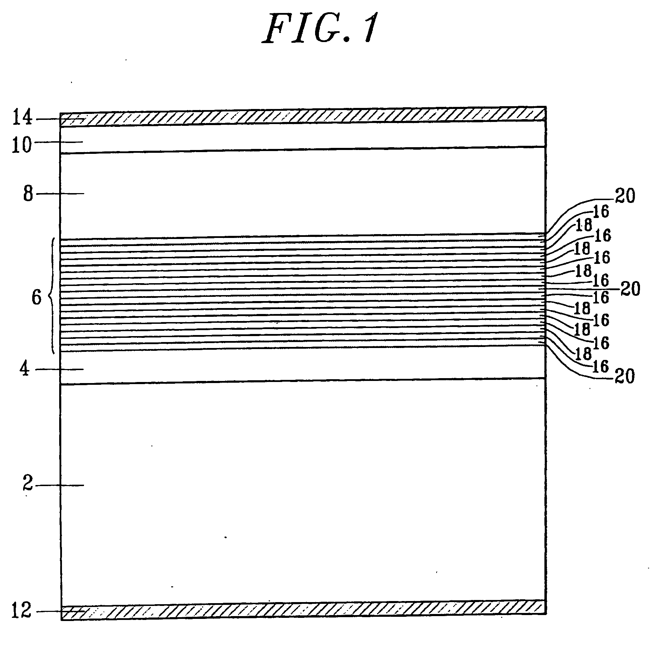

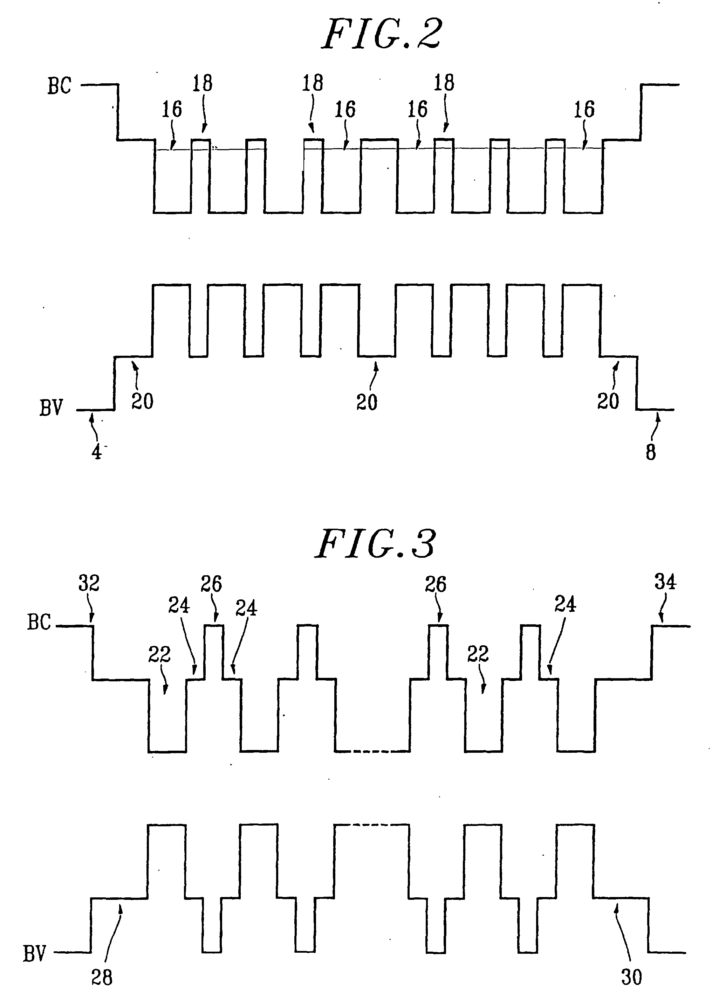

Une structure conforme à l'invention, destinée à un composant actif en onde guidée ayant une puissance de saturation élevée et présentant simultanément une insensibilité à la polarisation est schématiquement illustrée par les figures 1 et 2.

Elle utilise des couches de puits et des couches de barrières qui sont contraintes en tension (par rapport au substrat sur lequel repose la structure et qui est beaucoup plus épais que celle-ci).

Pour avoir de bonnes performances (taux d'extinction élevé et large bande passante notamment), il est préférable d'utiliser un grand nombre de puits et un grand nombre de barrières.

Pour compenser les contraintes de tension des couches de puits et des couches de barrières, cette structure comprend aussi des couches intercalaires contraintes en compression.

Ces couches intercalaires satisfont aux conditions suivantes :
- leur contrainte est suffisante pour compenser les contraintes des couches de puits et des couches de barrières,
- leur largeur de bande interdite est supérieure ou égale à la largeur de bande interdite des couches de barrières, et
- elles sont suffisamment minces pour ne pas bloquer les porteurs de charge (électrons et trous).

La figure 1 montre aussi, de façon schématique, un composant actif en onde guidée conforme à la présente invention, qui contient la structure considérée.

Ce composant de la figure 1 est un modulateur électro-absorbant qui, grâce à cette structure, est insensible à la polarisation et qui a une grande puissance de saturation.

Le modulateur de la figure 1 comprend :
- un substrat 2 en InP dopé n,
- une couche-tampon 4 en InP dopé n, qui est formée sur ce substrat 2,
- une multicouche semiconductrice intrinsèque à puits quantiques 6, qui constitue une zone active et qui est formée sur la couche 4,
- une couche 8 en InP dopé p, qui est formée sur cette zone active 6, et
- une couche de contact 10 en InGaAs dopé p⁺, qui est formée sur la couche 8.

De façon connue, la face inférieure du substrat 2, face opposée à celle sur laquelle est formée la couche 4, est recouverte par une couche métallique 12 formant une électrode tandis que la couche de contact 10 est recouverte par une couche métallique 14 formant une autre électrode.

On rappelle que pour faire fonctionner un tel modulateur, on lui applique une tension de polarisation inverse (« *reverse bias voltage* »).

Pour ce faire, l'électrode 14 est polarisée négativement par rapport à l'électrode 12.

La couche 4 de type n et la couche 8 de type p forment également des couches de confinement optique (« *optical cladding* »).

La structure de type p-i-n du modulateur de la figure 1 est formée par une technique d'épitaxie en phase vapeur aux organométalliques.

Conformément à l'invention, la zone active 6 constitue une structure à puits quantiques comprenant des couches de puits 16 et des couches de barrières 18 qui alternent les unes avec les autres et sont toutes contraintes en tension (par rapport au substrat 2).

De plus, la zone 6 comprend des couches intercalaires 20 qui alternent avec des groupes de couches de puits et de couches de barrières.

Ces couches intercalaires 20 sont, quant à elles, contraintes en compression pour compenser les contraintes de tension des couches de puits et des couches de barrières.

Dans l'exemple représenté sur la figure 1, la structure à puits quantiques conforme à l'invention comprend deux groupes de couches de puits et de couches de barrières qui sont compris entre trois couches intercalaires 20.

On précise que, de manière générale, le nombre de couches de puits et de couches de barrières de chaque groupe est tel que son épaisseur soit inférieure à l'épaisseur critique à partir de laquelle il se produit une relaxation de l'empilement constitué par un tel groupe, c'est-à-dire une séparation de cet empilement du substrat.

Dans l'exemple représenté sur la figure 1, chaque groupe comprend quatre couches de puits 16 et trois couches de barrières 18.

Dans cet exemple de la figure 1 :
- les couches de puits 16 sont en In_{0,52}Ga_{0,48}As_{0,95}P_{0,05} non dopé,
- les couches de barrières sont en In_{0,52}Ga_{0,48}As_{0,68}P_{0,32} non dopé, et
- les couches intercalaires sont en InAs_{0,49}P_{0,51}.

De plus, les couches de puits 16 ont une épaisseur de 8,5 nm et sont contraintes en tension à -0,25%.

Les couches de barrières 18 ont une épaisseur de 5 nm et sont contraintes en tension à -1,1%.

Les couches intercalaires 20 ont une épaisseur de 7 nm et sont contraintes en compression à +1,7%.

La constitution de cette structure à puits quantiques conforme à l'invention, qui est contenue dans le modulateur de la figure 1, se retrouve sur la figure 2.

Celle-ci illustre schématiquement la structure de bandes de cette structure à puits quantiques.

Sur cette figure 2, les bandes de valence et les bandes de conduction sont respectivement notées BV et BC.

On voit aussi que, dans l'exemple de la figure 1, la largeur de bande interdite des couches intercalaires est égale à la largeur de bande interdite des couches de barrières.

Des mesures effectuées sur le modulateur de la figure 1 ont conduit aux résultats suivants.

Ce modulateur a une sensibilité à la polarisation qui est inférieure à 0,5 dB sur toute la gamme de tensions appliquées au modulateur (O V à -1,5 V) et sur une grande gamme de longueurs d'onde (1,53 µm à 1,56 µm).

La puissance de saturation de ce modulateur a été caractérisée par la mesure du temps d'échappement des porteurs de charge en régime de photo-détection.

Ce temps d'échappement ne dépasse pas 20 ps, même avec de faibles tensions appliquées (inférieures à 0,2 V).

Ce temps d'échappement est à comparer à ceux qui sont obtenus avec des modulateurs électro-absorbants connus et qui vont de 250 ps à 2000 ps.

Pour différentes longueurs d'onde et différentes tensions appliquées au modulateur de la figure 1, la puissance optique de sortie varie de façon linéaire jusqu'à 16 dBm (40 mW) : aucune saturation n'est observée jusqu'à cette valeur.

La figure 3 illustre schématiquement une autre structure à puits quantiques conforme à l'invention.

Cette figure 3 montre la structure de bandes de cette structure à puits quantiques.

Les bandes de valence et les bandes de conduction sont encore respectivement notées BV et BC.

Dans le cas de la figure 3, la structure à puits quantiques comprend encore des groupes de couches de puits 22 et de couches de barrières 24, ces dernières alternant avec les couches de puits.

Ces groupes sont séparés les uns des autres par des couches intercalaires 26 qui ont une largeur de bande interdite supérieure à la largeur de bande interdite des couches de barrières 24.

Les couches de puits 22 et les couches de barrières 24 sont encore contraintes en tension tandis que les couches intercalaires 26 sont contraintes en compression et compensent les contraintes de tension des couches de puits et des couches de barrières.

L'ensemble des couches de puits, des couches de barrières et des couches intercalaires est compris entre deux couches de confinement optique 28 et 30.

Et le tout est compris entre deux couches en InP référencées 32 et 34.

La présente invention n'est pas limitée à l'utilisation de couches de la famille InGaAsP.

L'invention peut également être mise en oeuvre avec des couches de matériaux de la famille InGaAlAs.

On peut également réaliser une structure à puits quantiques conforme à l'invention dans laquelle les couches de puits et les couches de barrières sont contraintes en compression (par rapport au substrat de la structure) tandis que les couches intercalaires sont contraintes en tension pour compenser les contraintes induites par les couches de puits et les couches de barrières.

Une telle structure est utilisable dans des composants auxquels on veut donner d'autres propriétés que l'insensibilité à la polarisation et la grande puissance de saturation.

## Revendications

1. Structure à puits quantiques pour composant optique actif en onde guidée, cette structure comprenant des couches semiconductrices de puits (16, 22) qui alternent avec des couches semiconductrices de barrières (18, 24),où
les couches de puits et les couches de barrières sont contraintes, la contrainte résultante n'étant pas nulle, et en ce que la structure comprend en outre des couches intercalaires (20, 26) qui sont électriquement et optiquement inactives, alternent avec des groupes de couches de puits et de couches de barrières et sont aptes à compenser cette contrainte résultante.
**caractérisée en ce que** les couches de puits (16, 22) et les couches de barrières (18, 24) sont contraintes en tension, la structure étant ainsi insensible à la polarisation et de grande puissance de saturation, et **en ce que** les couches intercalaires (20, 26) sont contraintes en compression pour compenser les contraintes de tension dues aux couches de puits et aux couches de barrières.

2. Structure selon la revendication 1, **caractérisée en ce que** la largeur de bande interdite des couches intercalaires (20, 26) est supérieure ou égale à la largeur de bande interdite des couches de barrières (18, 24).

3. Structure selon l'une quelconque des revendications 1 et 2, **caractérisée en ce que** les couches de puits (16, 22), les couches de barrières (18, 24) et les couches intercalaires (20, 26) sont faites de matériaux semiconducteurs appartenant à la famille de matériaux InGaAsP.

4. Structure selon l'une quelconque des revendications 1 et 2, **caractérisée en ce que** les couches de puits, les couches de barrières et les couches intercalaires sont faites de matériaux semiconducteurs appartenant à la famille de matériaux InGaAlAs.

5. Composant optique actif en onde guidée, ce composant étant **caractérisé en ce qu'**il comprend une structure conforme à l'une quelconque des revendications 1 à 4..

6. Composant selon la revendication 5, **caractérisé en ce qu'**il comprend une couche active semiconductrice intrinsèque (6) comprise entre une couche de confinement (4) semiconductrice de type n et une couche de confinement (8) semiconductrice de type p et **en ce que** cette couche active comprend une structure conforme à l'une quelconque des revendications 2 à 5, permettant au composant de former un modulateur électro-absorbant à puits quantiques.

## Patentansprüche

1. Quantentopfstruktur für aktive optische Wellenleiter-Komponenten mit Halbleiter-Quantentopfschichten (16, 22) die sich mit Halbleiter-Sperrschichten (18, 24) abwechseln,
bei der die Quantentopfschichten und die Sperrschichten verspannt sind, wobei die resultierende Spannung nicht gleich Null ist, die Struktur außerdem elektrisch und optisch inaktive Zwischenschichten (20, 26) umfaßt, die sich mit den Gruppen von Quantentopfschichten und Sperrschichten abwechseln und diese resultierende Spannung kompensieren können,
**dadurch gekennzeichnet, daß** die Quantentopfschichten (16, 22) und die Sperrschichten (18, 24) zugverspannt sind, so daß die Struktur gegen Polarisation und hohe Sättigungsleistung unempfindlich ist, und daß die Zwischenschichten (20, 26) druckverspannt sind, um die durch die Quantentopfschichten und die Sperrschichten bedingten Zugspannungen auszugleichen.

2. Struktur nach Anspruch 1, **dadurch gekennzeichnet, daß** die Breite der Bandlücke der Zwischenschichten (20, 26) größer als oder gleich der Breite der Bandlücke der Sperrschichten (18, 24) ist.

3. Struktur nach einem der Ansprüche 1 und 2, **dadurch gekennzeichnet, daß** die Quantentopfschichten (16, 22), die Sperrschichten (18, 24) und die Zwischenschichten (20, 26) aus Halbleiter-Materialien der Familie der InGaAsP-Materialien hergestellt sind.

4. Struktur nach einem der Ansprüche 1 und 2, **dadurch gekennzeichnet, daß** die Quantentopfschichten, die Sperrschichten und die Zwischenschichten aus Halbleiter-Materialien der Familie der InGaAlAs-Materialien hergestellt sind.

5. Aktive optische Wellenleiter-Komponente, **dadurch gekennzeichnet, daß** sie eine Struktur gemäß einem der Ansprüche 1 bis 4 aufweist.

6. Komponente nach Anspruch 5, **dadurch gekennzeichnet, daß** sie eine zwischen einer Halbleiter-Sperrschicht (4) vom n-Typ und einer Halbleiter-Sperrschicht (8) vorn p-Typ angeordnete, eigenleitende aktive Halbleiterschicht (6) aufweist und daß diese aktive Schicht eine Struktur gemäß einem der Ansprüche 2 bis 5 umfaßt, wodurch die Komponente einen Elektro-Absorptions-Modulator bilden kann.

## Claims

1. Quantum well structure for an active optical waveguide component, this structure comprising semiconductor well layers (16, 22) alternating with semiconductor barrier layers (18, 24), where
the well layers and the barrier layers are strained, the resulting strain not being nil, and in that the structure also comprises intermediate layers (20, 26) which are electrically and optically inactive, alternating with groups of well layers and barrier layers and which are able to compensate for the resulting strain.
**characterized in that** the well layers (16, 22) and the barrier layers (18, 24) are tensile strained, the structure thus being polarization insensitive and having great saturation power, and **in that** the intermediate layers (20, 26) are compressively strained to compensate for the tensile strains in the well layers and in the barrier layers.

2. Structure according to claim 1, **characterized in that** the energy gap of the intermediate layers (20, 26) is greater than or equal to the energy gap of the barrier layers (18, 24).

3. Structure according to any one of claims 1 and 2, **characterized in that** the well layers (16, 22), the barrier layers (18, 24) and the intermediate layers (20, 26) are made of semiconductor materials from the InGaAsP family of materials.

4. Structure according to any one of claims 1 and 2, **characterized in that** the well layers, the barrier layers and the intermediate layers are made of semiconductor materials from the InGaAlAs family of materials.

5. Active optical waveguide component, this component being **characterized in that** it comprises a structure according to any one of claims 1 to 4.

6. Component according to claim 5, **characterized in that** it comprises an intrinsic semiconductor active layer (6) between an n-type semiconductor cladding layer (4) and a p-type semiconductor cladding layer (8) and **in that** this active layer comprises a structure according to any one of claims 2 to 5, allowing the component to form a quantum well electro-absorption modulator.
